Europäisches Patentamt

European Patent Office

Office européen des brevets

(19)

(11) Veröffentlichungsnummer : **0 128 600 B1**

## (12) EUROPÄISCHE PATENTSCHRIFT

(45) Veröffentlichungstag der Patentschrift :
15.03.89

(21) Anmeldenummer : 84200624.9

(22) Anmeldetag : 03.05.84

(51) Int. Cl.⁴ : **F 27 B 14/06**, H 05 B 6/22,
F 27 B 14/10

(54) Kalter Tiegel für das Erschmelzen und die Kristallisation nichtmetallischer anorganischer Verbindungen.

(30) Priorität : 06.05.83 DE 3316546

(43) Veröffentlichungstag der Anmeldung :
19.12.84 Patentblatt 84/51

(45) Bekanntmachung des Hinweises auf die Patenterteilung : 15.03.89 Patentblatt 89/11

(84) Benannte Vertragsstaaten :
AT CH DE FR GB LI

(56) Entgegenhaltungen :
DE—A— 2 402 833
GB—A— 495 862
GB—A— 811 918
GB—A— 1 463 071

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
CH FR GB LI AT

(72) Erfinder : Mateika, Dieter, Dr.
Seerosenstrasse 16
D-2087 Ellerbek (DE)
Erfinder : Laurien, Rolf
Am Wall 53
D-2080 Pinneberg (DE)
Erfinder : Liehr, Manfred
Strehlowweg 38
D-2000 Hamburg 52 (DE)

(74) Vertreter : Nehmzow-David, Fritzi-Maria et al
Philips Patentverwaltung GmbH Wendenstrasse 35
Postfach 10 51 49
D-2000 Hamburg 1 (DE)

## Beschreibung

Die Erfindung betrifft einen kalten Tiegel für das Erschmelzen und die Kristallisation nichtmetallischer anorganischer Verbindungen mit einer gekühlten Tiegelwandung in Form von von Kühlmedium durchströmten Metallrohren, die in mechanischer Verbindung stehen mit dem ebenfalls von Kühlmedium durchspülten Tiegelboden und mit einer Induktionsspule, die die Tiegelwandung umgibt und über die Hochfrequenzenergie in den Tiegelinhalt einkoppelbar ist.

Ein derartiger Tiegel ist geeignet für die Durchführung des sogenannten skull-melting-Verfahrens zum Erschmelzen von Ausgangsmaterialien für die Züchtung von Einkristallen durch direkte Einkopplung eines elektromagnetischen Feldes von einer Induktionsspule in das zu erwärmende Material.

Aus der Literaturstelle V. I. Aleksandrov, V. V. Osiko, A. M. Prokhorov und V. M. Tatarintsev : Synthesis and Crystal Growth of Refractory Materials by RF-Melting in a Cold Container, in : Current Topics in Materials Science, Vol. 1, ed. by E. Kaldis, North Holland Publ. Comp., 1978 ist ein derartiger Tiegel mit einer Wandung aus wassergekühlten Kupferrohren bekannt, die kreisförmig dicht an dicht nebeneinander angeordnet sind. Der Tiegelboden kann aus einer wassergekühlten Metallplatte oder aus mehreren Kupferrohren bestehen. Um den zylinderförmigen Tiegel ist eine Hochfrequenzspule angeordnet. Das elektromagnetische Feld koppelt durch die Spalte zwischen den Kupferrohren hindurch in das Innere des Tiegels ein.

Zum Schmelzen wird das Ausgangsmaterial im allgemeinen in Pulverform in einen derartigen Tiegel eingefüllt.

Schlechtleitende Oxide müssen zunächst vorgeheizt werden. Hierfür werden Metallstücke aus einem Metall, das dem des zu erschmelzenden Oxides entspricht, verwendet, die in das Pulver eingebettet werden. Das elektromagnetische Feld heizt aufgrund der induzierten Wirbelströme zunächst die Metallstücke auf, die ihrerseits das Oxidpulver in der näheren Umgebung aufschmelzen. In die sich bildende Schmelze kann das Feld der Hochfrequenz-Spule wegen der höheren elektrischen Leitfähigkeit der Schmelze direkt einkoppeln. Durch Erhöhung der Hochfrequenzleistung wird kontinuierlich weiteres Oxidpulver geschmolzen, bis sich Schmelze bis in die Nähe der Tiegelwand ausbildet. Die wassergekühlte innere Tiegelfläche sorgt dafür, daß sich zwischen ihr und der heißen Schmelze eine dichtgesinterte, in fester Phase vorliegende arteigene Schicht bildet, die den Tiegel vor dem Angriff durch die Schmelze schützt. Das zum Vorheizen benutzte Metall wird durch Sauerstoff der Luft in das zu erschmelzende Oxid umgewandelt.

Es hat sich nun gezeigt, daß mit dem bekannten Tiegel keine einwandfreien Kristalle gezüchtet werden können. Durch langsames Abkühlen der Schmelze können spontan an Tiegelboden und -wandung z. B. bis zu einige Zentimeter große Einkristalle wachsen, die sich gegenseitig beim Wachstum behindern. Die Folgen sind erhebliche mechanische Spannungen und andere Kristallbaufehler.

Der Erfindung liegt die Aufgabe zugrunde, einen kalten Tiegel zu konstruieren, bei dem die Kristallisation gezielt durchgeführt werden kann und mechanische Spannungen im Kristall und andere Kristallbaufehler verringert werden.

Diese Aufgabe wird erfindungsgemäß dadurch gelöst, daß unter dem Tiegelboden eine zweite Induktionsspule angeordnet ist, die unabhängig von der die Tiegelwandung umgebenden Induktionsspule schaltbar ist und daß der Tiegelboden aus dielektrischem Material besteht.

Der Erfindung liegt die Erkenntnis zugrunde, daß die Wachstumsbedingungen für aus der Schmelze zu züchtende Kristalle mittels kalter Tiegel verbessert werden können, wenn eine gezielte Beeinflussung der Temperaturverteilung in der Schmelze möglich ist, wenn also der Temperaturgradient in der Schmelze einstellbar ist. Es wurde zunächst versucht, eine getrennte Erhitzung der zu erschmelzenden Ausgangsmaterialien in einem Tiegel, der insgesamt aus Metall bestand, vom Tiegelboden her durch eine getrennt zu schaltende zweite Induktionsspule unterhalb des Tiegelbodens anzustreben ; Versuche brachten jedoch nicht den gewünschten Erfolg. Der Erfindung liegt die weitere Erkenntnis zugrunde, daß ein Grund für den Mißerfolg die erheblichen elektrischen Verluste im metallischen Tiegelboden sein könnten.

Nach einer vorteilhaften Ausgestaltung der Erfindung besteht der Tiegelboden aus einer Platte, vorzugsweise aus Quarz, unter der Kühlmedium fließt und die in eine Halterung aufgenommen ist, die mit federnd gelagerten Stützen in Verbindung steht. Dadurch, daß die Stützen federnd gelagert sind, ergibt sich der Vorteil, daß die Ausdehnung der Schmelze beim Aufheizen kompensiert wird, so daß eine Zerstörung der Quarzplatte, die bei nicht eine Wärmedehnung des Tiegelinhaltes kompensierenden Stützen eintreten kann, verhindert wird. Dadurch, daß Ausdehnungskräfte in vertikaler Richtung beim Schmelzprozeß durch die federnde Haltung des Tiegelbodens größtenteils kompensiert werden können, verlängert sich die Standzeit der Tiegel erheblich.

Nach einer weiteren vorteilhaften Ausgestaltung der Erfindung sind die die Tiegelwandung bildenden Metallrohre mittels mindestens eines Verteilerringes mechanisch gehalten, wobei der Verteilerring mittels einer Antriebsvorrichtung vertikal bewegbar ist. Hiermit ist der Vorteil verbunden, daß der Tiegel nach abgeschlossenem Kristallisationsprozeß auf einfache Weise entleert werden kann dadurch, daß der obere Tiegelteil, die Tiegelwandung, vom Tiegelboden nach oben abgehoben und der oder die Kristalle nach unten aus dem offenen Zylinder herausgestoßen werden kann (können).

Dadurch, daß der z. B. durch Wasser gekühlte Tiegelboden nur aus dielektrischen Materialien besteht, ergibt sich der Vorteil, daß bei induktiver Beheizung vom Boden her keine elektrischen Verluste im Tiegelboden auftreten.

Dadurch, daß zwei getrennt schaltbare Induktionsspulen eingesetzt werden, ergibt sich der Vorteil, daß die in den Tiegelinhalt einzukoppelnde Energiemenge örtlich dosierbar wird, es kann also je nach Bedarf mit Energie unterschiedlicher Frequenz gearbeitet werden, wobei z. B. jeweils sowohl ein Hochfrequenz- als auch ein Mittelfrequenz-Generator allein oder auch beide Generatoren gleichzeitig zum Erschmelzen des Tiegelinhaltes eingesetzt werden können. Es kann zweckmäßig sein, eine örtlich unterschiedliche Erhitzung des Tiegelinhaltes nicht nur über die beiden getrennt zu schaltenden Induktionsspulen zu erreichen, sondern innerhalb des Tiegels, z. B. über dem Tiegelboden, Hilfskörper aus einem gegenüber der Schmelze inerten, elektrisch gut leitfähigen Material vorzusehen, welche durch das elektromagnetische Feld aufgrund induzierter Wirbelströme schnell und gezielt aufgeheizt werden können.

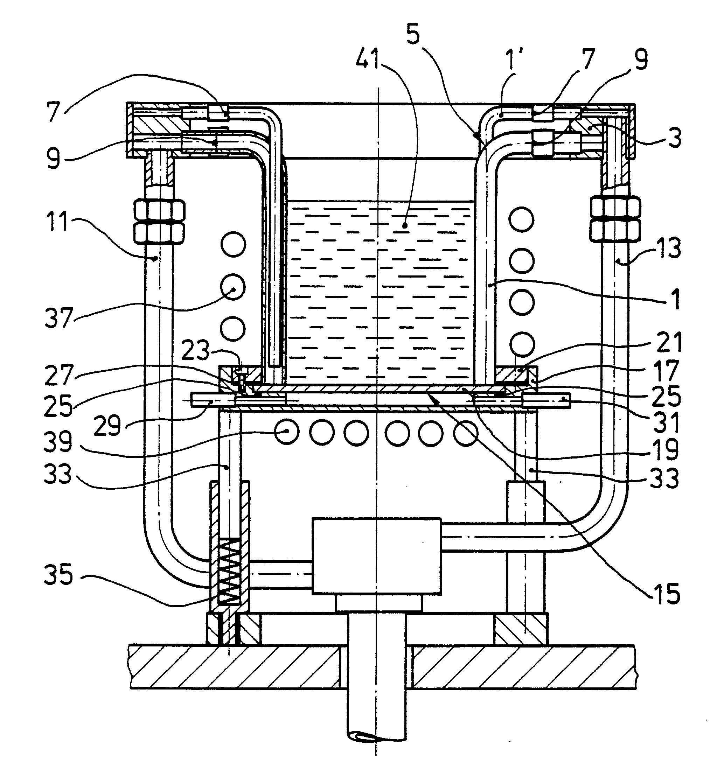

Anhand der Zeichnung wird ein Ausführungsbeispiel der Erfindung beschrieben und in seiner Wirkungsweise erläutert.

Die Figur zeigt einen kalten Tiegel nach der Erfindung im Schnitt. Die Tiegelwandung besteht aus von Kühlmedium, z. B. Wasser, durchflossenen, rechtwinklig gebogenen und doppelwandig ausgeführten Metallrohren 1, z. B. aus Kupfer, die kreisförmig angeordnet sind. Die Rohre 1 haben untereinander einen Abstand von 0,3 mm und einen Außendurchmesser von 10 mm und sind unten verschlossen. Das obere Ende der Rohre 1 ist in einen Verteilerring 3 eingelötet, der der Zufuhr von Kühlmedium dient. Ein inneres Rohr 1' durchstößt im Bereich einer Krümmung 5 das äußere Rohr 1 und ist über einen Krümmer gleichfalls mit dem Verteilerring 3 verbunden. Die Verbindung der Rohre 1 und 1' erfolgt über Lötstellen 7 und 9 ; diese Lötstellen 7 und 9 ermöglichen bei einem Defekt einen schnellen und einfachen Austausch eines Rohres 1 und 1'. Der Verteilerring 3 mit den Rohren 1, 1' ist verbunden mit jeweils mehreren Kühlmittelzu- und -abläufen 11 und 13. Es ist vorteilhaft, die Rohre 1 zum Schutz gegen Oxidation mit einer Schutzschicht zu versehen. Im Fall von Kupferrohren hat sich eine ungefähr 6 μm dicke Rhodium-Schicht bewährt.

Der Tiegelboden 15 besteht aus einem tragenden Grundkörper 17 aus dielektrischem Material, einer Platte 19 aus gegenüber der Schmelze inertem dielektrischem Material, z. B. Quarz, und einem Haltering 21, ebenfalls aus dielektrischem Material, z. B. $Al_2O_3$. Der Grundkörper 17 kann aus einem hitzebeständigen Kunststoff bestehen und enthält Ausnehmungen zur Aufnahme der Platte 19 und des Halteringes 21, wobei der Haltering 21 mit dem Grundkörper 17 fest verbunden ist z. B. über Schrauben 23, z. B. aus Nylon.

Durch eine Verschraubung ist es möglich, die Platte 19 auf einen O-Ring 25 zu drücken, der zur Abdichtung gegen das Kühlmedium dient. Um lokale mechanische Spannungen zwischen dem Haltering 21 und der Platte 19 zu verringern, ist zwischen diesen beiden Teilen ein elastischer Ring 27, z. B. aus Tetrafluoräthylen, angeordnet. Als Ein- bzw. Austrittsöffnungen für das Kühlmedium dienen Anschlüsse 29 und 31. Der Tiegelboden 15 ist mit Stützen 33 verbunden, die federnd gelagert sind. Die Federn 35 haben die Aufgabe, die Ausdehnung einer im Tiegel befindlichen Schmelze beim Aufheizen zu kompensieren, so daß eine Zerstörung der Platte 19 verhindert wird. Mittels einer nicht dargestellten mechanischen Antriebsvorrichtung kann der Verteilerring 3 mitsamt den Rohren 1, 1' in vertikaler Richtung bewegt werden, also in Richtung weg vom Tiegelboden 15 nach oben gezogen oder in Richtung auf ihn abgesenkt werden. Der in diesem Ausführungsbeispiel beschriebene kalte Tiegel hat einen Innendurchmesser von 121 mm, die maximale Füllhöhe beträgt 120 mm. Um die Tiegelwandung, bestehend aus den Rohren 1, ist eine Induktionsspule 37 angebracht. Sie ist mit einem Generator verbunden, dessen Arbeitsfrequenz zwischen 1 und 7 MHz liegt. Unterhalb des Tiegelbodens 15 ist eine weitere Induktionsspule 39 angeordnet, die mit einem Generator gleicher oder anderer Arbeitsfrequenz als der für den mit der Induktionsspule 37 verbundenen Generator betrieben wird. Der mit der Induktionsspule 39 verbundene Generator hat z. B. eine Arbeitsfrequenz von 7-10 kHz. Beide Generatoren können unabhängig voneinander geschaltet werden.

Zur Inbetriebnahme des Tiegels wird der Verteilerring 3 mit den Rohren 1, 1' auf die Kühlmittelzu- und -abläufe 11 und 13 aufgesetzt, verschraubt und mittels der Antriebsvorrichtung gegen den federnd gelagerten Tiegelboden 15 gefahren. Der Haltering 21 umschließt die Rohre 1 und gibt dem Tiegel eine zusätzliche Stabilität gegen das Verbiegen der Rohre 1. Nach Beendigung des Schmelz- bzw. Kristallisationsprozesses wird die aus den Rohren 1 gebildete Tiegelwandung nach oben vom Tiegelboden 15 abgezogen. Der kristallisierte Tiegelinhalt kann dann sehr leicht aus dem offenen Zylinder nach unten herausgestoßen werden. In der Figur ist der Tiegelinhalt als Schmelze 41 dargestellt.

**Patentansprüche**

1. Kalter Tiegel für das Erschmelzen und die Kristallisation nichtmetallischer anorganischer Verbindungen mit einer gekühlten Tiegelwandung in Form von von Kühlmedium durchströmten Metallrohren, die in mechanischer Verbindung stehen mit dem ebenfalls von Kühlmedium durchspülten Tiegelboden und mit einer Induktionsspule, die die Tiegelwandung umgibt und über die Hochfrequenzenergie in den Tiegelinhalt einkoppelbar ist, dadurch gekennzeichnet, daß unter dem Tiegelboden (15) eine zweite Induktionsspule (39) angeordnet ist, die unabhängig von der die Tiegelwandung umgebenden Induktionsspule schaltbar ist und daß der Tiegelboden aus dielektrischem Material besteht.

2. Kalter Tiegel nach Anspruch 1, dadurch gekennzeichnet, daß der Tiegelboden (15) aus einer Platte (19) besteht, unter der das Kühlmedium fließt und die in eine Halterung (17, 21) aufgenommen ist, die mit federnd gelagerten Stützen (33) in Verbindung steht.

3. Kalter Tiegel nach Anspruch 1, dadurch gekennzeichnet, daß die die Tiegelwandung bildenden Metallrohre (1) mittels mindestens eines Verteilerringes (3) mechanisch gehaltert sind, wobei der Verteilerring mittels einer Antriebsvorrichtung vertikal bewegbar ist.

4. Kalter Tiegel nach Anspruch 1, dadurch gekennzeichnet, daß die die Tiegelwandung bildenden Metallrohre (1) aus Kupfer bestehen.

5. Kalter Tiegel nach Anspruch 2, dadurch gekennzeichnet, daß die Platte (19) aus Quarz besteht.

6. Kalter Tiegel nach Anspruch 4, dadurch gekennzeichnet, daß die Metallrohre (1) mit einer eine Oxidation hemmenden Beschichtung versehen sind.

7. Kalter Tiegel nach Anspruch 6, dadurch gekennzeichnet, daß die Beschichtung aus Rhodium besteht.

## Claims

1. A cold crucible for melting and crystallizing non-metallic inorganic compounds, comprising a cooled crucible wall in the form of metal pipes through which cooling medium flows and which are in mechanical connection with the bottom of the crucible through which cooling medium flows also, and comprising an induction coil which surrounds the wall of the crucible and via which high-frequency energy can be coupled into the contents of the crucible, characterized in that a second induction coil (39) which can be switched independently of the induction coil surrounding the wall of the crucible is arranged below the bottom (15) of the crucible and that the bottom of the crucible consists of a dielectric material.

2. A cold crucible as claimed in Claim 1, characterized in that the bottom (15) of the crucible consists of a plate (19) below which the cooling medium flows and which is accommodated in a holder (17, 21) which is connected to resiliently supported supports (33).

3. A cold crucible as claimed in Claim 1, characterized in that the metal pipes (1) forming the wall of the crucible are mechanically held by means of at least one distributor ring (3), the distributor ring being movable vertically by means of a driving device.

4. A cold crucible as claimed in Claim 1, characterized in that the metal pipes (1) forming the wall of the crucible consist of copper.

5. A cold crucible as claimed in Claim 2, characterized in that the plate (19) consists of quartz.

6. A cold crucible as claimed in Claim 4, characterized in that the metal pipes (1) are provided with a layer inhibiting oxidation.

7. A cold crucible as claimed in Claim 6, characterized in that the layer consists of rhodium.

## Revendications

1. Creuset froid pour la fusion et la cristallisation de composés inorganiques non métalliques comportant une paroi de creuset refroidie sous forme de tubes métalliques qui sont traversés par du fluide de refroidissement et qui sont en liaison mécanique avec le fond de creuset également traversé par du fluide de refroidissement ainsi qu'une bobine d'induction qui entoure la paroi de creuset et qui peut être couplée à l'aide d'énergie à haute fréquence au contenu du creuset, caractérisé en ce qu'au-dessous du fond (15) du creuset est disposée une deuxième bobine d'induction (39) qui peut être commutée indépendamment de la bobine d'induction entourant la paroi du creuset et que le fond du creuset est constitué par du matériau diélectrique.

2. Creuset froid selon la revendication 1, caractérisé en ce que le fond de creuset (15) est constitué par une plaque (19) au-dessous de laquelle circule le fluide de refroidissement et qui est logée dans un support (17, 21) qui est relié à des appuis (33) qui sont disposés de façon élastique.

3. Creuset froid selon la revendication 1, caractérisé en ce que les tubes métalliques (1) constituant la paroi du creuset sont supportés mécaniquement à l'aide d'au moins un anneau distributeur (3), l'anneau distributeur (3) pouvant être déplacé verticalement à l'aide d'un dispositif d'entraînement.

4. Creuset froid selon la revendication 1, caractérisé en ce que les tubes métalliques (1) constituant la paroi du creuset sont en cuivre.

5. Creuset froid selon la revendication 2, caractérisé en ce que la plaque (19) est constituée par du quartz.

6. Creuset froid selon la revendication 4, caractérisé en ce que les tubes métalliques (1) sont munis d'une couche qui ralentit l'oxydation.

7. Creuset froid selon la revendication 6, caractérisé en ce que la couche est constituée par du rhodium.